Europäisches Patentamt

European Patent Office

Office européen des brevets

(19)

(11) EP 0 789 388 B1

(12) EUROPEAN PATENT SPECIFICATION

(45) Date of publication and mention
of the grant of the patent:
**19.10.2005 Bulletin 2005/42**

(51) Int Cl.[7]: **H01L 21/285**, H01L 21/04

(21) Application number: **96306139.5**

(22) Date of filing: **22.08.1996**

(54) **Fabrication method for schottky electrodes onto semiconductor devices**

Herstellungsverfahren von Schottky Elektroden auf Halbleitervorrichtungen

Procédé de fabrication d'électrodes Schottky sur des dispositifs semi-conducteurs

(84) Designated Contracting States:
**DE FR GB**

(30) Priority: **25.08.1995 JP 21693595**
**25.03.1996 JP 6801896**

(43) Date of publication of application:
**13.08.1997 Bulletin 1997/33**

(73) Proprietor: **AGENCY OF INDUSTRIAL SCIENCE AND TECHNOLOGY**
**Chiyoda-ku Tokyo (JP)**

(72) Inventors:
• **Hara, Shiro**
**Tsukuba-shi, Ibaraki (JP)**
• **Kajimura, Koji**
**Tsukuba-shi, Ibaraki (JP)**
• **Okushi, Hideyo**
**Tsukuba-shi, Ibaraki (JP)**
• **Teraji, Tokuyuki**
**Tsukuba-shi, Ibaraki (JP)**

(74) Representative: **Beresford, Keith Denis Lewis**
**BERESFORD & Co.**
**16 High Holborn**
**London WC1V 6BX (GB)**

(56) References cited:
**EP-A- 0 111 364       EP-A- 0 452 661**
**US-A- 4 060 820       US-A- 4 301 592**
**US-A- 5 087 322       US-A- 5 270 252**

• **S. M. SZE: "Physics or Semiconductor Devices" 1981 , JOHN WILEY & SONS , NEW YORK XP002068071 * page 245 - page 311 ***

• **ADEGBOYEGA G A ET AL: "SCHOTTKY CONTACT BARRIER HEIGHT ENHANCEMENT ON P-TYPE SILICON BY WET CHEMICAL ETCHING" APPLIED PHYSICS A. SOLIDS AND SURFACES, vol. A48, no. 4, 1 April 1989, pages 391-395, XP000112320**
• **CHANDRIKA NARAYAN: "TUNING OF THE SCHOTTKY BARRIER HEIGHT USING BI-METALLIC LAYERED STRUCTURES" APPLIED PHYSICS LETTERS, vol. 59, no. 20, 11 November 1991, pages 2541-2542, XP000330120**
• **PATENT ABSTRACTS OF JAPAN vol. 095, no. 003, 28 April 1995 & JP 06 333892 A (FUJI ELECTRIC CORP RES & DEV LTD), 2 December 1994,**
• **TERAJI T ET AL: "Ohmic contacts to n-type 6H-SiC without post-annealing" III-NITRIDE, SIC AND DIAMOND MATERIALS FOR ELECTRONIC DEVICES. SYMPOSIUM, III-NITRIDE, SOC AND DIAMOND MATERIALS FOR ELECTRONIC DEVICES. SYMPOSIUM, SAN FRANCISO, CA, USA, 8-12 APRIL 1996, 1996, PITTSBURGH, PA, USA, MATER. RES. SOC, USA, pages 149-154, XP002068069**
• **HARA S ET AL: "Pinning-controlled metal/semiconductor interfaces" THIRD INTERNATIONAL CONFERENCE ON INTELLIGENT MATERIALS. THIRD EUROPEAN CONFERENCE ON SMART STRUCTURES AND MATERIALS, LYON, FRANCE, 3-5 JUNE 1996, vol. 2779, ISSN 0277-786X, PROCEEDINGS OF THE SPIE - THE INTERNATIONAL SOCIETY FOR OPTICAL ENGINEERING, 1996, SPIE-INT. SOC. OPT. ENG, USA, pages 802-806, XP002068070**
• **E.H. RHODERICK, R.H. WILLIAMS: "Metal-Semiconductor Contacts" 1988, OXFORD UNIVERSITY PRESS , OXFORD**

- T. Teraji et al., Ti Ohmic contact without post-annealing process to n-type 6H-SiC, Institute of Physics Conference Series, No 142, Chapter 3, Paper presented at Silicon Carbide and Related Materials 1995, Kyoto, Japan, 18-21 September 1995
- VANDERVORST W ET AL: "Advanced Characterisation: an Indispensable Tool for Understanding Ultra Clean Processing" MICROELECTRONIC ENGINEERING, vol. 28, no. 1, 1 June 1995 (1995-06-01), pages 27-34, AMSTERDAM, NL
- TUCKER J R ET AL: Nanoscale FETs and STM Lithography, HIGH SPEED SEMICONDUCTOR DEVICES AND CIRCUITS, 1995, PROCEEDINGS, IEEE/CORNELL CONFERENCE ON ADVANCED CONCEPTS IN ITHACA, NY, USA, IEEE, US, pages 425-434, 7 August 1995
- MURARKA S P: "Silicide Thin Films and their Applications in Microelectronics" INTERMETALLICS, vol. 3, no. 3, 1995, pages 173-186, GB
- WATANABE S ET AL: "Homogeneous Hydrogen-terminated Si(111) Surface Formed usng Aqueous HF Soltution and Water" APPLIED PHYSICS LETTERS, vol. 59, no. 12, 16 September 1991 (1991-09-16), pages 1458-1460, NEW YORK, US

**Description**

The present invention relates to a method of manufacturing an electrode on a semiconductor, in particular the manufacture of a Schottky contact on silicon carbide (SiC) semiconductor. For example, the present invention can be applied in the manufacture of various semiconductor devices such as microprocessors, memories, power devices and the like.

In conventional methods of manufacturing electrodes on semiconductors, the magnitudes of rectifying potential barriers, i.e., Schottky barriers, which will appear on the interfaces between electrode metals and semiconductors, have been impossible to control. Hence, it has been impossible to control the rectifying properties and conductivities of all the electrodes including not only those semiconductor devices whose performance depends directly on the heights of Schottky barriers, such as Schottky diodes as typical examples, but also those electrodes in the semiconductor devices thus far fabricated. The Schottky barrier height and leakage current, which is an indicator of important performance of an interface of a device, inconveniently vary to a greater extent depending on the combinations of metals and semiconductors as well as on the processes in which the interfaces are formed. Conventionally, this problem has been solved empirically. That is, when a new semiconductor has been developed, a method of manufacturing an electrode on the semiconductor has been investigated and developed for each metal one after another until a suitable one is obtained. In other words, going into detail, there have conventionally been developed unique methods of manufacturing electrodes adapted for respective combinations of semiconductors and electrode metal materials. Because of having had to resort to empirical rules, methods for fabricating electrodes differ from institution to institution or from manufacturer to manufacturer. There has been established no method of manufacturing electrodes which can be uniformly applied to any or most electrode metal/semiconductor combinations. Under the circumstances, development of electrodes has needed much human and monetary resources for investigation. In all the semiconductor device fabrication technology inclusive of technologies for fabricating integrated semiconductor devices such as VLSIs and the like, only the technology for forming electrodes has remained as a unit technology that is out of reach of successful efforts for free designing.

More specific explanation will be made as to how to manufacture Schottky electrodes.

In the case of Schottky electrodes, it has been almost impossible to control Schottky barrier height. For example, silicon Schottky diodes have almost fixed barrier heights on the order of about 0.5 to about 0.7 eV. While use of different metals or application of heat to cause interface reaction will vary barrier height to some extent, the width of change in barrier height is at most about 0.2 eV. Thus, in Schottky devices, the Schottky barrier height, which is the most important indicator for the device characteristics has not been controlled freely.

Electrodes have been fabricated based on empirical rules. The primary reason for this is a lack of common or uniform understanding of the mechanism in forming a metal/semiconductor interface potential barrier. Uncontrollability of Schottky barriers is due to the fact that Schottky barrier height is by nature fixed to a certain level. Fixation of Schottky barrier height of a semiconductor is equivalent to the fact that the Fermi level is fixed in the bandgap of the semiconductor on the metal/semiconductor interface. The fixation of Fermi level is usually referred to as pinning of the Fermi level. The pinning of the Fermi level occurs as a result of the generation of an electron level in the bandgap of a semiconductor at the interface between the metal and the semiconductor. Carriers flow from bulk to the interface, i. e., electrons in the case of n-type semiconductor or holes in the case of p-type semiconductor flow from the bulk semiconductor to the interface and the carriers are trapped therein to create an electric double layer of the semiconductor bulk and the interface, i.e., a potential barrier or Schottky barrier.

Reviewing the development of Schottky barrier, in 1947, J. Bardeen stated that the interface level is caused by electronic level due to dangling bonds and the like existing on the surface of the semiconductor (cf. J. Bardeen: Phys. Rev., 71, 717 (1947)). Thereafter, however, in view of the impossibility of controlling the surface level density accurately by the technology available at that time, the leading view was that surface level density was uncontrollable and intrinsic to the material concerned, and interface electron level embedded in a solid should be an essential electron level that was more difficult to control than the surface level. The belief that pinning was intrinsic to materials and cannot be controlled has led to a theory of MIGS (Metal-induced Gap States) which explains a cause of generation of interface levels (cf. V. Heine: Phys. Rev., 138, A1689 (1965)). According to this theory, interface levels are induced when a metal approaches toward the semiconductor. Since 1965 when V. Heine proposed it, the MIGS theory has been leading to date. The MIGS theory has inhibited research of a technology which controls the height of Schottky barrier. In fact, regardless of theories, there have been unavailable high technologies that can control interface level density in actual semiconductor devices.

Concerning numerical consideration of pinning, the work which referred to Schottky barrier for the first time was by W. Schottky (cf. W. Schottky: Naturwissenschaften, 26, 843 (1938) and N.F. Mott: Proc. Camb. Philos. Soc., 34, 568 (1938)). According to Schottky, the Schottky barrier height, $\varphi bn$, of a n-type semiconductor is given by the following equation (1):

$$\varphi bn = \varphi m - \chi S + C \tag{1}$$

wherein $\varphi m$ is a work function of the metal, $\chi S$ is electron affinity of the semiconductor, C is a constant no greater than several meV. On the other hand, the Schottky barrier height of a p-type semiconductor in a pinning-free state is given by the following equation (2):

$$\varphi bp = Eg - (\varphi m - \chi S + C) \tag{2}$$

wherein Eg is a bandgap.

The equations (1) and (2) are called Schottky models. However, no interface has been realized that meets these equations. The actual interface is expressed by the following equation (3):

$$\varphi bn = S(\varphi m - \chi S) + C \tag{3}$$

wherein S is a coefficient which indicates a dependence of $\varphi bn$ on $\varphi m$ and $0 \leq S \leq 1$.

When S=0, $\varphi bn$ is constant and the interface is pinned strongly. This state is called a Bardeen barrier. On the contrary, when S=1, the equation (3) is the same as the equation (1) and represents a pinning-free interface according to the Schottky-Mott model. Actual interfaces fall between the both states. Heretofore, the S factor has been believed to be a physical property specific to the material concerned and, hence, beyond control.

Table 1 below summarizes values of S factor and maximum and minimum values of Schottky barrier height of representative semiconductors.

Table 1

PINNING RATIOS S OF VARIOUS KNOWN SEMICONDUCTORS AND RANGE OF SCHOTTKY BARRIER HEIGHT

| SEMI-CONDUCTOR | S FACTOR | INTERCEPT PARAMETER | MINIMUM SCHOTTKY BARRIER HEIGHT [eV] | MAXIMUM SCHOTTKY BARRIER HEIGHT [eV] |
|---|---|---|---|---|
| Ge | $0.18 \geq S \geq 0.05$[1] | $-0.23 \leq C_2 \leq 0.11$[1] | | |
| Si(001) | $0.19 \geq S \geq 0.11$[1] | $-0.34 \leq C_2 \leq 0.35$[1] | $0.37(GdSi_2/HoSi_2)$[2] | $0.94(IrSi3)$[3] |
| GaAs(001) | $0.22 \geq S \geq 0.06$[1] | $-0.40 \leq C_2 \leq 0.075$[1] | $0.62(Mg)$[4] | $0.96(Cu)$[4] |
| GaP | $0.21 \geq S \geq 0.07$[1] | $0.45 \leq C_2 \leq 0.80$[1] | | |
| InP | $0.37 \geq S \geq 0.24$[1] | $-1.00 \leq C_2 \leq 0.81$[1] | | |
| ZnS | $0.66 \geq S \geq 0.21$[1] | $-1.63 \leq C_2 \leq 0.91$[1] | | |
| ZnSe | $0.24 \geq S \geq 0.17$[1] | $-0.25 \leq C_2 \leq 0.57$[1] | | |
| 6H-SiC(0001) | $0.25 \geq S \geq 0.23$[5-10] | $-3.5 \leq C_2 \leq 0.15$[5-10] | $0.73(Ti)$[6] | $1.37(Au)$[5] |

1. B.L. Sharma and S.C. Gupta, Solid State Technology, 23(6), 90 (1980).
2. K.N. Tu, R.D. Thompson, and B.Y.Tsaur, Appl. Phys. Lett. 38, 626(1981).
3. C.S. Petersson, et al., J. Appl. Phys., 50, 3357 (1979).
4. J.R. Waldrop, J. Vac. Sci. Technol., B2, 445 (1984).
5. J.R. Waldrop, et al., J. Appl. Phys., 72, 4757 (1992).
6. J.R. Waldrop, et al., Appl. Phys. Lett., 62, 2685 (1993).
7. L.M. Porter, et al., Mat. Res. Soc. Symp. Proc., 287, 471 (1993).
8. L.M. Porter, et al., J. Mat. Res., 10, 26 (1995).
9. L.M. Porter, et al., J. Mat. Res., 10, 668 (1995).
10. L.M. Porter, et al., M. Mat. Res. 10, 2336 (1995).

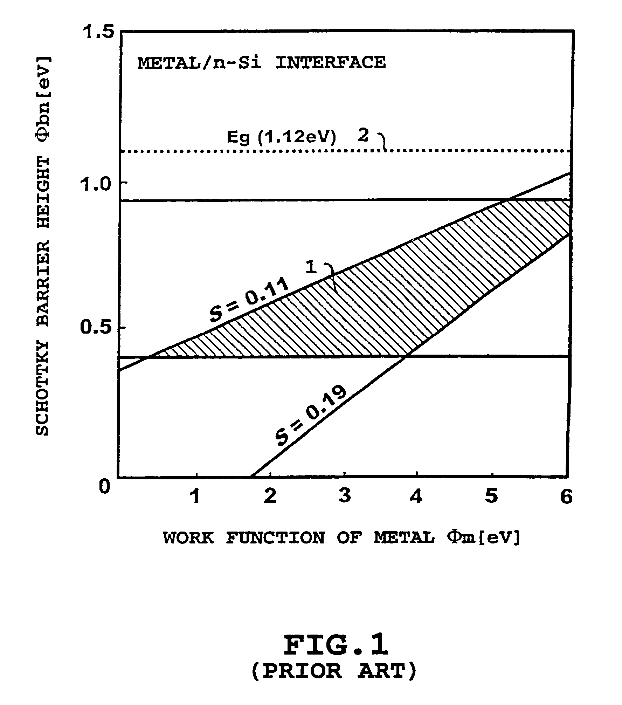

Fig. 1 is a graphical presentation of the data in Table 1, plotting Schottky barrier height ($\varphi bn$ [eV]) against work function of a metal ($\varphi m$ [eV]) taking as an example of an n-type Si(001) semiconductor substrate. Fig. 1 shows that the Schottky barrier height has been limited within a certain range for various metals. In Fig. 1, reference numeral 1 denotes an area representing the range in which the Schottky barrier heights of conventionally fabricated metal/n-Si interfaces fall and 2 denotes a line which represents an absolute upper limit of the Schottky barrier height of metal/n-Si interfaces corresponding to the bandgap Eg=1.12 eV. With different metals, there are always upper and lower limits of the Schottky barrier heights.

Consequently, it has heretofore been impossible to freely control the Schottky height of metal/semiconductor interfaces.

The present invention is directed to overcoming the problem of uncontrollability of the Schottky barrier height between an electrode metal and a SiC semiconductor, which problem has been an important subject since the transistor was invented.

More specifically, the present invention is directed to overcoming the problem of uncontrollability of pinning of Fermi level of the interface of metal/semiconductor that has been impossible to control conventionally.

A number of studies have been made of Schottky barrier contacts on SiC.

United States Patent US-A-5,270,252 discloses a method in which silicon carbide epitaxial material is grown on p-type (100) silicon substrates by chemical vapour deposition. The as-grown SiC has a rough surface and must be prepared prior to formation of the contact by any known method used to generate a smooth surface for formation of Schottky contacts. The preferred preparation of mechanically polishing the surface followed by oxidation and acid wash results in a damage-free polished SiC surface. A surface passivant, such as an oxide film, is formed on the SiC surface after which platinum metallization is deposited by e-beam evaporation, RF or magnetron sputtering. One or more platinum Schottky contacts are deposited to a thickness of 75-100 nm (750-1000 angstroms). After formation of the platinum Schottky contacts, their electrical characteristics will not degrade in temperatures up to 800°C.

One important aspect of the disclosed method of US-A-5,270,252 is the formation of platinum silicide by the platinum Schottky contact upon exposure to high temperatures. At temperatures above 450°C platinum from the metal layer on the SiC appears to move into SiC and form platinum silicide which also exhibits stable rectifying characteristics. It also forms a barrier layer to inhibit migration of the silicon into the platinum which can cause electrical degradation of the contact. Formation of the platinum silicide can be initiated by annealing, ion bombardment, direct deposition from a platinum silicide source or any other known method of inducing metal migration into a substrate.

In accordance with the present invention there is provided a method of manufacturing a Schottky contact on a semiconductor substrate, comprising the steps of:

providing a semiconductor substrate having a 6H-SiC (0001) face;

oxidizing the 6H-SiC (0001) face surface of the semiconductor substrate to form an oxide film;

removing said oxide film; then

immersing the 6H-SiC (0001) face surface of said semiconductor substrate in boiling water so as to flatten that surface; and then

depositing electrode metal for forming a Schottky contact on the flattened 6H-SiC (0001) face surface of said semiconductor substrate and forming therefrom said Schottky contact.

Here, the Schottky barrier height of the Schottky electrode is determined by the flatness of the electrode metal/semiconductor interface, and the work function of the metal.

The step of oxidizing the silicon carbide surface of the semiconductor substrate may be carried out by heating the silicon carbide in an oxidative gaseous atmosphere.

Removing the oxide film may be carried out by reacting the oxide film with a reducing liquid or gas.

The electrode material may be titanium Ti, Mo, Ni, or Au, for example.

The above and other advantages of the present invention will become more apparent from the following description of background comparative examples and specific examples thereof taken in conjunction with the accompanying drawings.

Fig. 1 is a graph plotting Schottky barrier height of a Schottky electrode fabricated on an n-type Si(001) substrate by a conventional method against the work function of the electrode metal;

Fig. 2 is a graph illustrating regions representing Schottky barrier heights ;

Fig. 3 is a graph illustrating current-voltage characteristics of Ti electrodes on SiC;

Fig. 4 is a graph illustrating current-voltage characteristics of a Ti electrode on SiC which has been subjected to a conventional treatment with 5% hydrofluoric acid;

Fig. 5 is a graph illustrating current-voltage characteristics of an Al electrode on SiC;

Fig. 6 is another graph illustrating current-voltage characteristics of Al electrodes on SiC;

Fig. 7 is a graph illustrating current-voltage characteristics of an Al electrode on Si(111) which has been subjected to a conventional treatment with 5% hydrofluoric acid;

Fig. 8A is a sketch prepared based on an optical micrograph of the surface of a Ti electrode manufactured by the method according to EXAMPLE 4;

Fig. 8B is a schematic cross sectional view showing the Ti electrode illustrate in Fig. 8A;

Fig. 9A is a sketch prepared based on an optical micrograph of the surface of an Ni electrode manufactured by a conventional method;

Fig. 9B is a schematic cross sectional view showing the Ti electrode illustrated in Fig. 9A;

Fig. 10 is a graph illustrating logarithmic current-voltage characteristics of Au electrodes on 6H-SiC(0001) substrates according to EXAMPLE 7, a specific example of the present invention;

Fig. 11 is a graph plotting Schottky barrier height of electrode metals fabricated on 6H-SiC(0001) substrates against the work function of the electrode metals; and

Fig. 12 is a graph illustrating new areas for Schottky barrier heights of electrode metals fabricated on 6H-SiC(0001) substrates using the techniques of the present invention.

In order to solve the problem of uncontrollability of Schottky barrier height, it is only necessary to decrease the interface states density of the interface between an electrode metal and a semiconductor on which the electrode metal layer is formed.

A decrease in the interface states density is realized by decreasing the surface states density of the semiconductor before deposition of a metal thereon. The decrease in the surface states density can be realized primarily by flattening the surface of the semiconductor on an atomic level.

Flattening of the surface of the semiconductor results in a decrease in an atomic step density which generates dangling bond density which is a cause of surface states and in an amount of unstable atoms adsorbed on the surface of the semiconductor. It has been found that flattening of the surface of the semiconductor on an atomic level decreases the surface states density of the semiconductor and that a decrease in the surface states density is effective for decreasing the interface states density of the electrode metal/semiconductor structure.

Description will be made on how to flatten the surface of a semiconductor on an atomic level. An example of such a method is to set up conditions of oxidation appropriately so that oxidation can proceed flat on an atomic level, thus making the surface of the semiconductor after etching more flattened than the original surface.

Another method is a treatment with dilute hydrofluoric acid adjusted to have an appropriate pH. The pH of the solution can be rendered alkaline with ammonia water. Such a solution has an activity of flattening the surface of a semiconductor on an atomic level by means of a weak etching action of a lot of OH groups contained in the solution. Similarly, a semiconductor may be immersed in boiling water. This method can flatten the surface of a semiconductor on an atomic level by means of a weak etching action of deionized water.

Hereinbelow, the idea of flattening semiconductor surfaces on an atomic level will be described in more detail. To be flat on an atomic level means existence of wide flat terraces when viewed on an atomic level. This directly indicates that an atomic step density is low in the surface concerned. Atoms at a step generally have more dangling bonds than atoms on a terrace. While the dangling bonds on a terrace will disappear after the formation of an interface with a metal due to bonding with the metal, the dangling bonds at a step will not disappear completely because of the step or difference in height as high as the thickness of one atomic layer. Therefore, after the formation of an interface, a main cause of generation of interface states is dangling bonds at steps. In other words, a decrease in a step density will result in a decrease in an interface level density. Hence, in order to decrease an interface states density, it is sufficient to flatten the surface of a semiconductor so that its step density can be decreased. Thus, even if the surface is not flattened when viewed on a scale on the order of micrometers, existence of wide terraces in more minute regions will suffice for decreasing interface states. Therefore, electrode structures with an interface having wide terraces on an atomic level, even though they have uneven or rough surfaces when viewed in a broader region, will cause a decrease in surface states density.

If the interface states density is reduced enough, by one of the above-described methods, the pinning of Fermi level will disappear. On such a pinning-free interface, what determines its potential barrier is merely a difference between respective Fermi levels, i.e., a difference between respective work functions, of the metal and the semiconductor. In this case, Schottky-Mott model expressed by equations (1) and (2) above is followed. Therefore, in the case of an n-type semiconductor, use of a metal having a high work function results in the formation of a Schottky barrier while use of a metal having a low work function gives rise to an Ohmic contact. To control the Schottky barrier height, it is only necessary to select an appropriate metal with regard to work function. For p-type semiconductors, the same idea as that for n-type semiconductors can be applied except that relationship of the magnitudes of the work functions should be reversed.

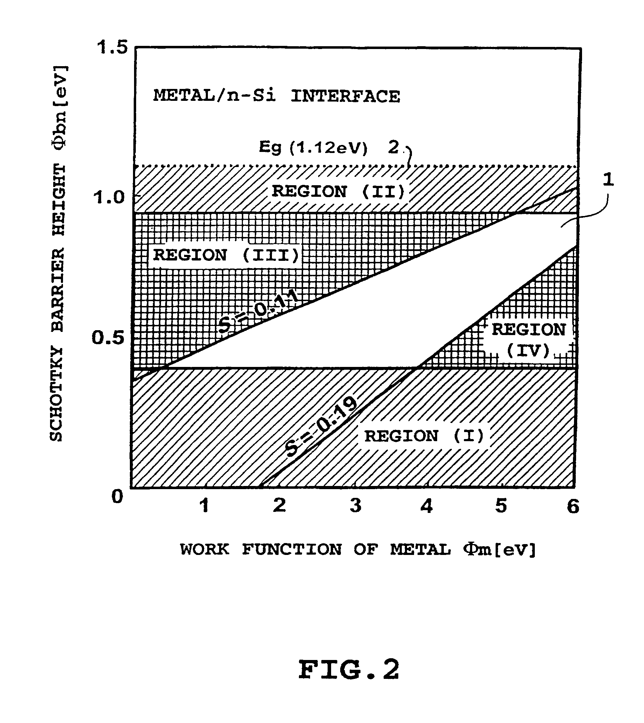

According to the present finding, the Schottky barrier height of a semiconductor can be expanded to a minimum value of 0 eV (cf. Fig. 2, region (I)) and a maximum value equivalent to the bandgap (cf. Fig. 2, region (II)).

Also, controlling the degree of pinning will in effect vary the Schottky height and, hence, controlling interface level density will enable control of the Schottky barrier height even when the same metal is used. That pinning can be controlled means that the Schottky barrier height can be controlled at will for each metal. As a result, the region where the Schottky barrier height can be controlled is expanded to regions (III) and (IV) in Fig. 2.

As described above, it is possible now to expand the region where the Schottky barrier height can appear from region (1) to regions (I) to (IV) in Fig. 2. Table 1 above indicates the Schottky barrier height regions that can now be reached for representative semiconductor materials.

Another important feature is that control of the Schottky property can be performed without heat treatment. However, if heat treatment is carried out after the deposition of electrode metals, still a flat interface can be obtained since originally a flat surface on an atomic level is provided, an interface reaction between the metal and the semiconductor occurs uniformly in the interface therebetween. Therefore, the present invention is also effective in the case of electrodes which are subjected to heat treatment.

The present invention is applied to the manufacture of Schottky contact electrodes on silicon carbide (SiC). While SiC is a material with which p- and n-type semiconductors can be used with ease, they have various excellent physical properties such as large bandgap. Since in the present invention, processes are used that do not involve heat treatment, no appreciable interface chemical reaction does occur between the metal and the semiconductor. Therefore, the resulting interface receives the conditions of the surface of the semiconductor without any change, and the interface has electrical characteristics which depend on structural and chemical properties of the surface of SiC before the deposition of the electrode metal. In other words, control of the conditions of the surface of SiC makes it possible to control electric properties freely.

When no treatment is performed on the surface of SiC, a natural oxide film is formed thereon. Also, a lot of water and/or impurity atoms are adsorbed on the SiC surface. Further, in the case of as ground surfaces, there are near the surface a lot of impurity atoms contaminating or defects induced upon grinding. Such conditions depend strongly on the process by which the SiC surface is made so that the resulting surface does not always have the same surface atomic conditions and surface electronic state.

In the present invention, a method is used which depends strongly on the conditions of surface atoms as described above. Therefore, a surface layer must be removed. For this purpose, SiC is oxidized and then the resulting oxide film is removed. The oxidation and removal of the oxide film may be performed simultaneously.

As a specific example of oxidation method for oxidizing silicon carbide (SiC), there can be used a method in which SiC is heated in an oxidizing gas atmosphere. The oxidation can be carried out at a heating temperature within the range of usually 800 to 1,250°C, preferably 950 to 1,150°C.

Metals which do not have high work functions are those metal materials composed mainly of elements other than noble metals (Ni, Pd, Pt, Cu, Ag, and Au) having high work functions, such as Ni which has been used conventionally. More specifically, this comprises a wide variety of metals, including, for example, Mg, Ca, Sr, Ba, Sc, Y, La, Ti, Zr, Hf, V, Nb, Ta, Cr, Mn, Re, Fe, Al, Ga, In, Tl and the like. Among these, those metals having not so high an oxidizing capability, are e.g., Ti and Al.

Metals having high work functions include noble metals such as Ni, Pd, Pt, Cu, Ag, and Al and metals having approximately the same work function as the noble metals, such as Co, Rh, Ir, Ru, Os, and Re.

Practically, metals are divided into low and high work function metals when they have work functions up to 4.5 eV or higher than 4.5 eV. However, 4.5 eV is not a strict threshold value. This is because when a metal is deposited on SiC at ambient (room) temperature, e.g., about 20°C, mutual diffusion of the atoms constituting the metal and the atoms constituting the SiC semiconductor may occur on the metal/semiconductor interface and effective work function alters, if the metal used is highly reactive. So, 4.5 eV is to be understood to be a practical standard for classifying metals.

The oxidation step may be carried out by an oxidative gaseous atmosphere. Usually, a sample is placed in an oxidative atmosphere in an apparatus which enables heating of the sample, such as electric oven, and the sample is heated at a temperature within the range of 800 to 1,250°C. With this treatment, the surface of the sample becomes insulating due to formation of an oxide film thereon and a sufficient electric contact is not achieved. Then, the oxide film is removed with a reducing liquid or gas. It is often the case that the atoms on the surface of SiC are arranged or accumulate in a manner different from the atoms in the bulk of the SiC. The oxidation step in an oxidative gaseous atmosphere is meant to oxidize such a denatured surface layer and make the surface layer ready to be removed by a liquid process including dissolving the surface oxide layer with a reducing liquid to remove it, or gaseous process involving reducing the surface oxide layer with a reducing gas to convert the oxide layer to a semiconductor of non-oxidized state.

In conventional processes for manufacturing electrodes, immersion or dipping of a semiconductor in a dilute hydrofluoric acid has been conducted to remove spontaneous oxide film on the surface of SiC. However, no intentional or artificial oxidation of SiC has been performed so that the unstable surface layer has not been removed completely.

According to the method of the present invention, development of Schottky electrodes, which has heretofore been made relying on experience or empirical rules, can be made in a shorter time than before since the present invention is based on a systematized knowledge. Thus, efforts for the development of electrodes can be minimized. The method of manufacturing electrodes according to the present invention does not need heat treatment, which makes a great increase in stability of the electrode structure as compared with the conventional method in which heat treatment is essential.

It is found now that Schottky barrier heights, that have been almost impossible to control by conventional methods, can be controlled freely by controlling interface level density and selecting work function of metals.

It is only necessary to make the surface of the SiC semiconductor as flat as possible on an atomic level.

Hereinafter, the present invention will be described in greater detail with reference to the examples and to the attached drawings. Examples 1 to 6 concern background only, whilst examples 7 and 8 are specific to the present invention. However, the present invention should not be construed as being limited thereto.

EXAMPLE 1 Confirmation of Ohmic Property (SiC-Ti Structure)

In the instant example, vacuum sublimated n-type 6H-SiC was used as a semiconductor substrate immediately after it was ground. The substrate had a carrier density of about $1x10^{17}$ cm$^{-3}$. At this carrier density, usually, the semiconductor was not metallic and it was difficult to produce an Ohmic contact. The substrate was cleaned using methanol and trichloroethylene, and then placed in an electric oven filled with an oxygen gas atmosphere and oxidized at 300 °C for 30 minutes, followed by 800°C for 10 minutes. Thus an oxide film of about 5 nm thick was formed. The substrate was dipped in 5% hydrofluoric acid to remove the oxide film.

On the thus-obtained SiC substrate was deposited titanium (Ti), which is a representative high melting metal and has a low work function. The work function of Ti was 4.4 eV, which is by 0.9 eV lower than Ni, which has conventionally been used as an Ohmic electrode and has a work function of 5.3 eV. The SiC substrate used was not heated previously. The thickness of deposited film was about 500 nm. Deposition was not carried out on the entire surface of the semiconductor but through a metal mask formed with a round hole of 0.30 mm in diameter for subsequent electrical measurements.

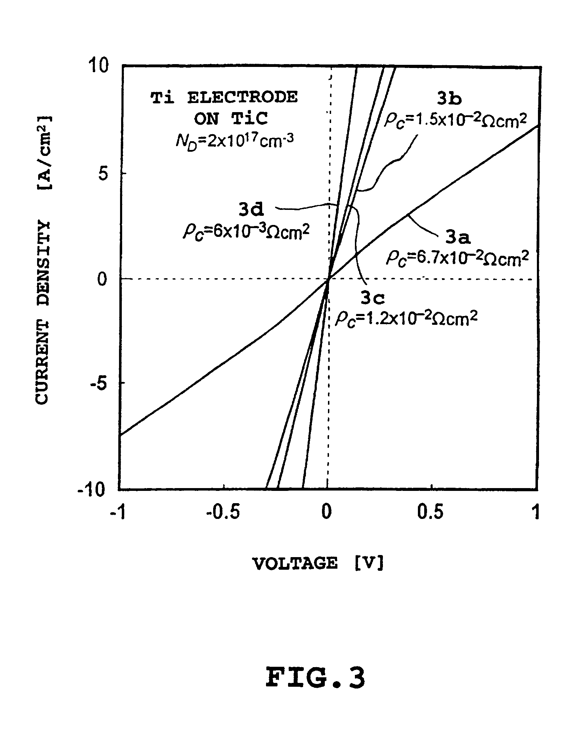

Fig. 3 is a graph illustrating current-voltage (I-V) characteristics of the sample taken out of the vacuum apparatus (cf. line 3a). As apparent from Fig. 3, the line 3a is a straight line. Lack of nonlinearity as shown by the straight line 3a in Fig. 3 clearly indicates that the electrode obtained is Ohmic, that is, current is proportional to voltage. The interface resistance of the resulting electrode was $6.7x10^{-2}$ $\Omega$cm$^2$. The electrode made of a SiC material having a low carrier density as low as $2x10^{17}$ cm$^{-3}$ had an Ohmic contact which had theoretically the lowest resistance.

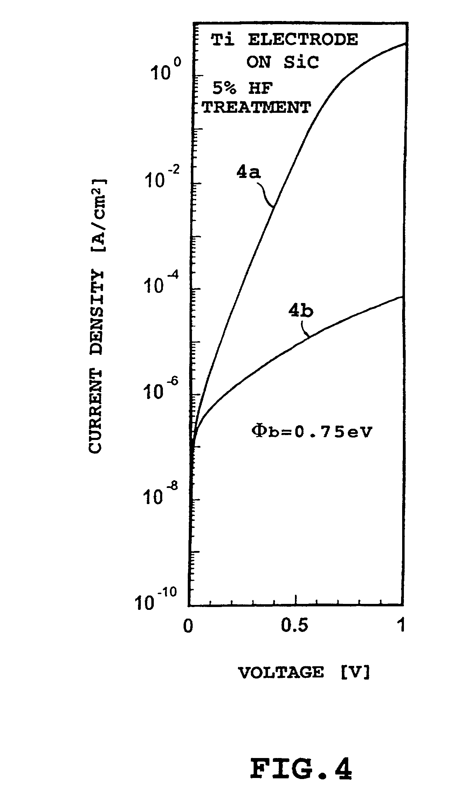

An electrode structure was made in the same manner as in EXAMPLE 1 except that no oxidative etching was conducted but only dipping in 5% hydrofluoric acid was performed (COMPARATIVE EXAMPLE 1). The comparative electrode structure showed no Ohmic property but exhibited Schottky property (Fig. 4). In Fig. 4, curves 4a and 4b show normal and reverse direction leakage currents, respectively.

EXAMPLE 2 Confirmation of Ohmic Property (SiC-Al structure)

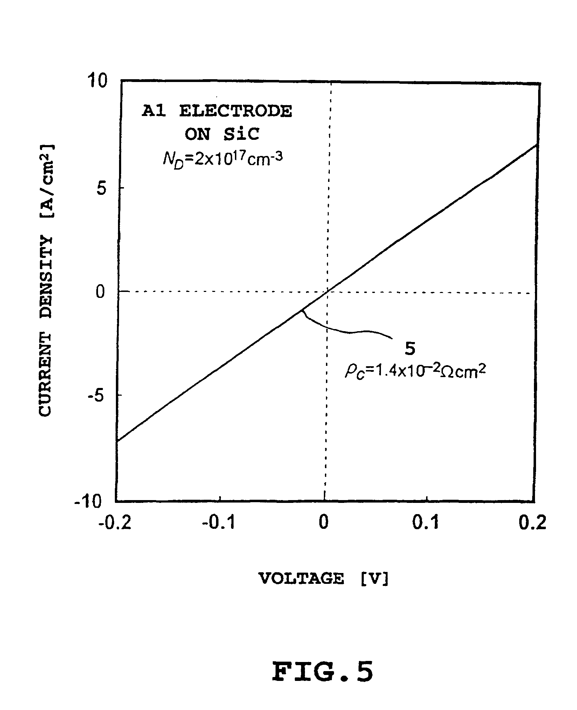

Next, an electrode structure was fabricated in the same manner as in EXAMPLE 1 except that instead of Ti there was used aluminium (Al), which is a non-transient, low melting point metal and belonging to group III of the periodic table. In this case, too, was obtained an Ohmic contact similar to that fabricated in EXAMPLE 1. The work function of Al is 4.3 eV. Fig. 5 shows current-voltage characteristics of the aluminum electrode fabricated under the same conditions as the Ti electrode. Similarly to EXAMPLE 1, a line 5 representing the current-voltage characteristics of the Al electrode showed linearity and the interface resistance was about $1.4x10^{-2}$ $\Omega$cm$^2$. The electrode made of a SiC material having a low carrier density as low as $2x10^{17}$ cm$^{-3}$ had an Ohmic contact which had theoretically the lowest resistance.

What is common between EXAMPLE 1 and EXAMPLE 2 is that the both metals used have work functions by about 1 eV lower than those of noble metals used as electrode metal for SiC in the conventional methods.

EXAMPLE 3 Confirmation of Ohmic Property (Si-Al structure)

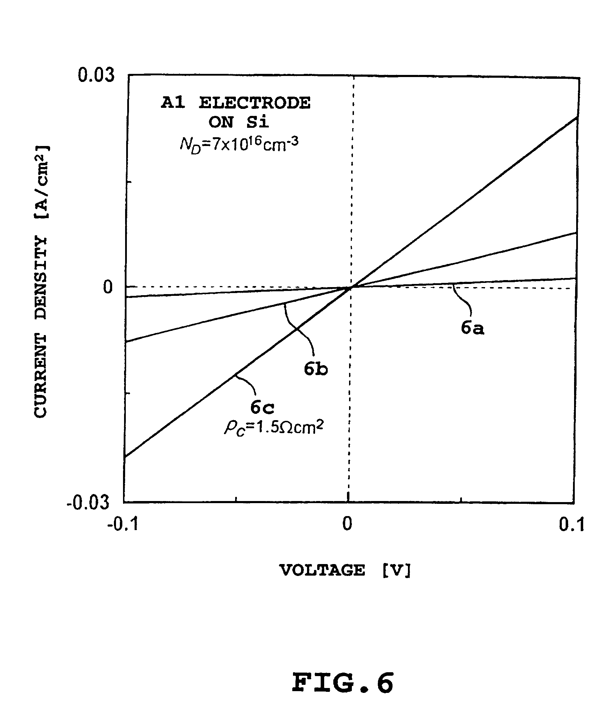

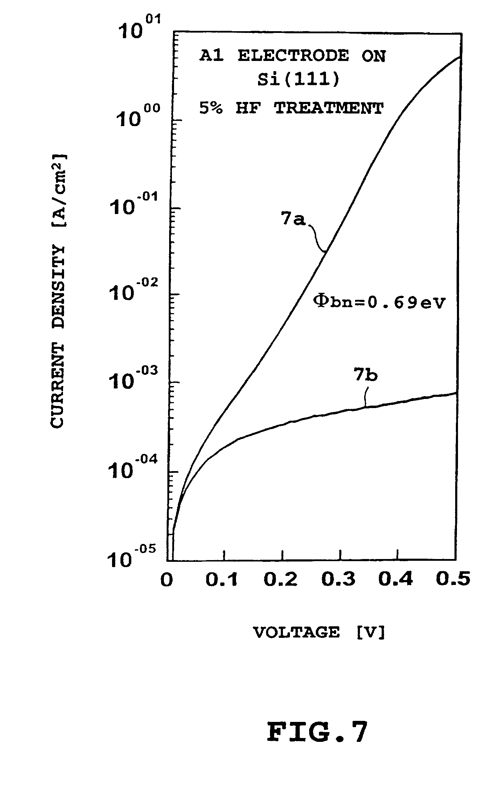

As a semiconductor substrate was used an n-type Si substrate having a carrier density of $7x10^{16}$ cm$^{-3}$. The substrate was cleaned using methanol and trichloroethylene, and then placed in an electric oven filled with an oxygen gas atmosphere and oxidized at 300°C for 30 minutes, followed by 800°C for 10 minutes. Thus an oxide film of about 50 nm thick was formed. The substrate was dipped in 5% hydrofluoric acid to remove the oxide film. The substrate thus obtained was dipped in hot water to make the surface of the semiconductor substrate flat on an atomic level. Thereafter, aluminum was deposited on the surface as an electrode metal. Fig. 6 illustrates current-voltage characteristics of the resulting electrode structure. A line 6a, which is a straight line, represents the sample with 5% hydrofluoric acid treatment. A line 6b, which is also a straight line, represents the sample with hot water treatment after 5% hydrofluoric acid treatment. A line 6c, which is also a straight line, represents the sample with 5% hydrofluoric acid treatment followed by hot water treatment. Here, by the term "hot water treatment" is meant a treatment with heated deionized water at a temperature below 100°C. From Fig. 6, it is apparent that the electrode is an Ohmic contact having a good linearity of current-voltage characteristics (the line 6c). Heretofore, as illustrated in Fig. 1, no metal could provide an Ohmic contact for Si substrates without high concentration doping. In fact, a comparative sample having an Si(111) surface which was not subjected to high concentration doping and having a carrier density of $7 \times 10^{16}$ cm$^{-3}$ (COMPARATIVE EXAMPLE 2) gave a Schottky barrier whose $\varphi$bn was 0.69 eV after receiving the same 5% hydrofluoric acid treatment as in the instant example (Fig. 7). In Fig. 7, curves 7a and 7b denote current flows in normal and reverse directions, respectively. Comparing the lines 6a to 6c in Fig. 6, it is observed that according as flattening processes are added or flatness increases, current increases and contact resistance decreases. In the instant example (the line 6c in Fig. 6), the doping concentration was $7 \times 10^{16}$ cm$^{-3}$, at which the width of the depletion layer is sufficiently thick and no tunneling will occur theoretically. Therefore, the Ohmic property observed in the sample of the instant example is considered to be attributable to a sufficiently decreased Schottky barrier.

EXAMPLE 4 Structural Uniformity of Electrode Structure

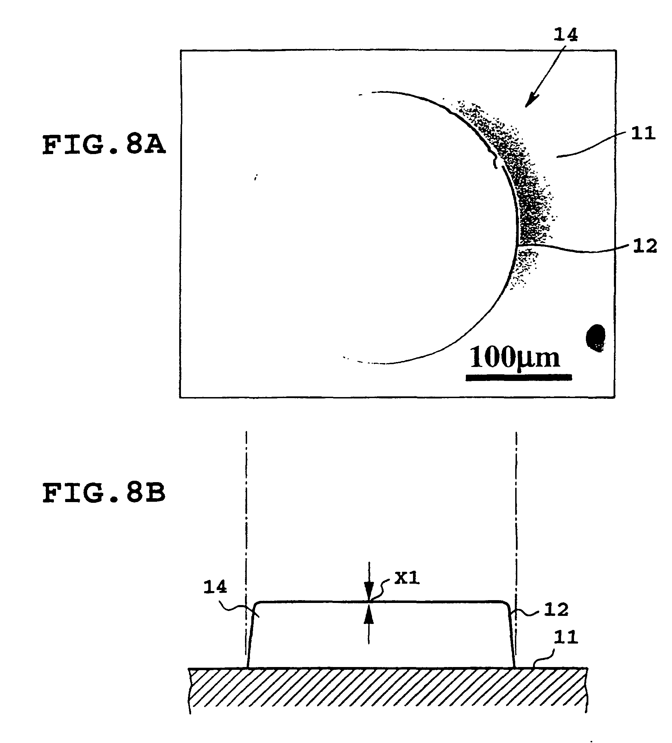

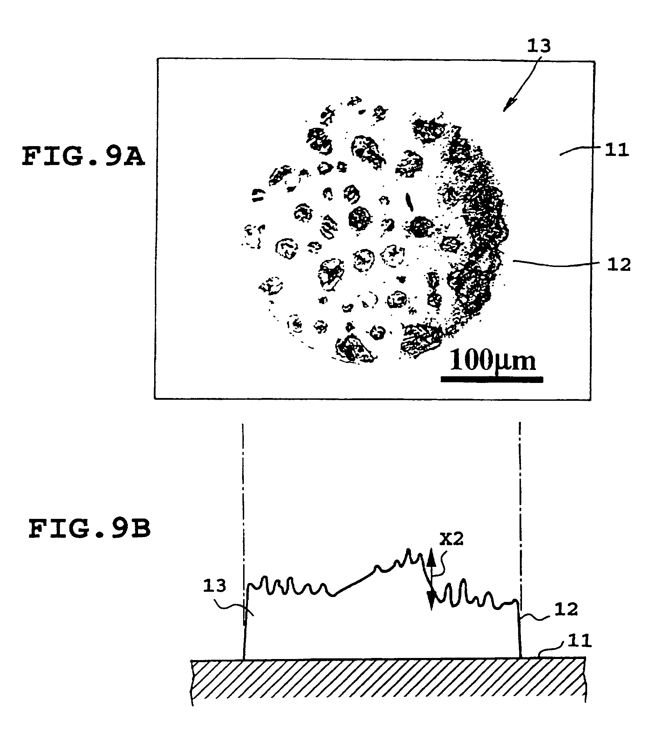

A Ti electrode was fabricated in the same manner as in EXAMPLE 1. Fig. 8A is an illustrative view prepared based on an optical micrograph of the surface of the Ti electrode. Fig. 8B is an expanded schematic cross sectional view showing the Ti electrode shown in Fig. 8A. As COMPARATIVE EXAMPLE 3, was prepared an Ni electrode by a conventional heat treatment method. The Ni electrode fabricated by cleaning using methanol and trichloroethylene, the same n-type SiC substrate as used in EXAMPLE 1, depositing Ni thereon by vapour deposition and then heating the substrate at 1,000°C for 60 minutes. Fig. 9A is an illustrative view prepared based on an optical micrograph of the surface of the Ni electrode. Fig. 9B is an expanded schematic cross sectional view showing the Ni electrode shown in Fig. 8A. In Figs. 8A and 9A, reference numeral 11 denotes an SiC substrate, 12 is an outline contour line of the electrode, 13 is an Ni electrode, and 14 is a Ti electrode. The both Ni and Ti electrodes were in the form of a disk of 0.3 mm in diameter. From Figs. 8A, 8B, 9A and 9B, it is apparent that the Ti electrode fabricated on SiC fabricated without heat treatment has a high flatness in surface. The Ni electrode 13 shown in Fig. 9A has a rough surface, clearly lacking structural uniformity. In contrast, in the Ti electrode 14 no region is observed where surface conditions are different, and the area inside a contour line 12 of the electrode 14 is uniform in appearance and highly flat, thus presenting excellent structure for Ohmic structure.
The electrode (Fig. 8B) had a surface with an unevenness (X1) of 5 nm or less. On the contrary, the electrode fabricated by the conventional method (Fig. 9B) had a surface with an unevenness (X2) of about 200 nm. This clearly indicates that the electrode of the present example had a surface flatness much superior to the electrode fabricated by the conventional method.

EXAMPLE 5 Dependence on Atomic Level Flattening Treatment - Epitaxial Growth

The same SiC substrate immediately after grinding as used in EXAMPLE 1 was dipped in boiling water (100°C) for 10 minutes. On the other hand, a sample was prepared by homoepitaxially growing SiC on the same SiC substrate after grinding as used in EXAMPLE 1. The sample was dipped in boiling water (100°C) for 10 minutes. Then, difference in current-voltage characteristics between the epitaxial SiC substrate and the SiC substrate immediately after grinding were examined. In the case of the epitaxial SiC substrate, an expectation will be made that flattening in surface proceeds sufficiently so that the interface level density decreases and as a result, the Schottky barrier height decreased and Ohmic property increases. In fact, the SiC substrate immediately after grinding had an interface resistance of $1.2 \times 10^{-2}$ $\Omega$cm$^2$ (the line 3c in Fig. 3) while the epitaxial SiC substrate had an improved interface resistance of $6 \times 10^{-3}$ $\Omega$cm$^2$ (the line 3d in Fig. 3). From this it follows that epitaxial growth is effective for flattening on an atomic level the surface of a semiconductor and for decreasing interface level density of the semiconductor.

EXAMPLE 6 Dependence on Atomic Level Flattening Treatment - pH Adjusted Dilute Hydrofluoric Acid Treatment

An oxidized/etched substrate having a current-voltage characteristics represented by the line 3a in Fig. 3 as used in EXAMPLE 1 was dipped in a pH adjusted dilute hydrofluoric acid for 10 minutes. Then, a metal was deposited on the surface of the thus obtained substrate. In Fig. 3, the line 3b represents the current-voltage characteristics of the electrode sample. In this case, the dilute hydrofluoric acid was adjusted to pH 10. Comparison of the line 3b with the line 3a shows that the interface resistance is improved to $1.5 \times 10^{-2}$ $\Omega$cm$^2$. As demonstrated in the instant example, pH adjusted dilute hydrofluoric acid treatment is also effective in decreasing interface level density.

EXAMPLE 7 Fabrication of a Schottky Electrode Showing Less Leakage

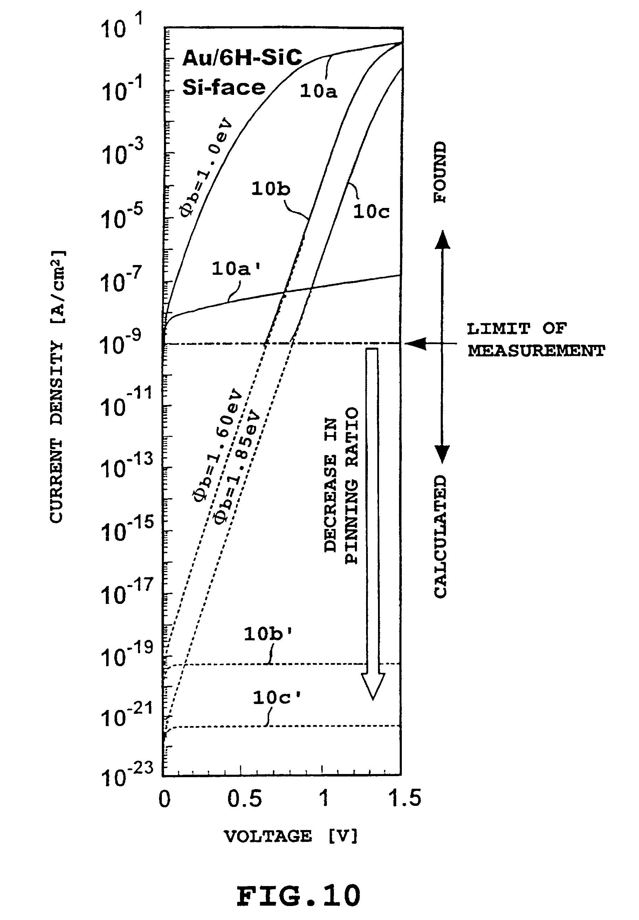

Fig. 10 illustrates current-voltage characteristics of gold (Au) electrode on 6H-SiC(0001) face. Lines 10a, 10b and 10c show normal direction leakage currents and 10a', 10b' and 10c' show reverse direction leakage currents. In the case of SiC surface with usual 5% hydrofluoric acid treatment, the reverse direction leakage current was on the order of $10^{-7}$ A/cm$^2$ (line 10a'). When oxidation/etching treatment was conducted, the reverse direction leakage current was decreased to $10^{-19}$ A/cm$^2$ or less (line 10b'), thus showing a drastic improvement in leakage characteristics by 12 digits. Furthermore, with additional boiling water treatment, the reverse direction leakage current was further improved by 2 digits to $10^{-21}$ A/cm$^2$ (line 10c'). This indicates that oxidation/etching treatment and boiling water treatment which accelerate flattening of the surface of the semiconductor weaken the pinning of the Schottky barrier. To note, in the instant example, the electrode itself was subjected to no heat treatment. Therefore, the instant example clearly shows that a high quality Schottky electrode can be made without heat treatment of the electrode.

EXAMPLE 8 Control of Pinning and Schottky Barrier Height

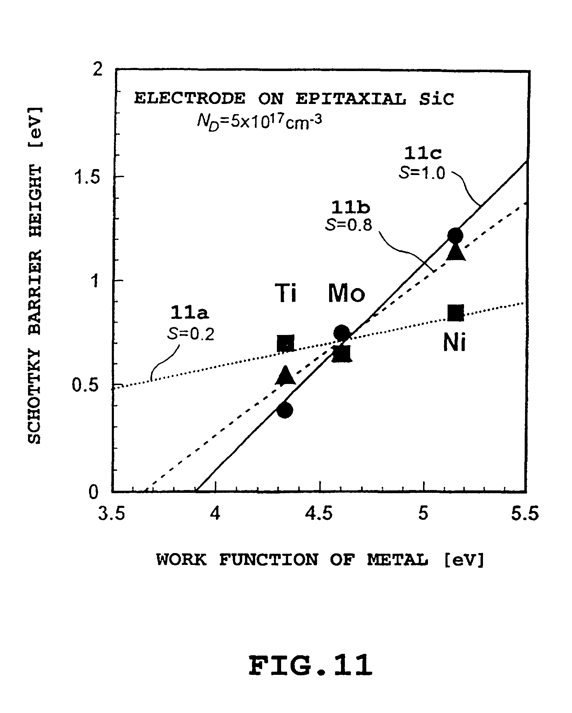

Fig. 11 illustrate Schottky barrier heights various metals deposited on a 6H-SiC(0001) face. The horizontal axis indicates work function of the metal. In the case of usual pretreatment with 5% hydrofluoric acid, the Schottky barrier height does not substantially depend on the work function of the metal and S factor which indicates an inclination of the line is about 0.2 (line 11a). Then, atomic level flattening of SiC was conducted by oxidation/etching treatment, S=0.8 was obtained, which indicates an almost pinning free state (line 11b). Further, boiling water treatment gives rise to S=1.0, which indicates no pinning is observed (line 11c). Thus, the present invention realized a pinning free state for 6H-SiC which inherently shows pinning. As a result, the Schottky barrier height can be freely changed merely by changing the work function of the metal as illustrated in Fig. 11 clearly. When the same metal is used, change in the process of atomic level flattening of the surface of the semiconductor results in varied Schottky barrier height. Note that for Ti electrodes, Schottky barrier heights were theoretically estimated from contact resistance values.

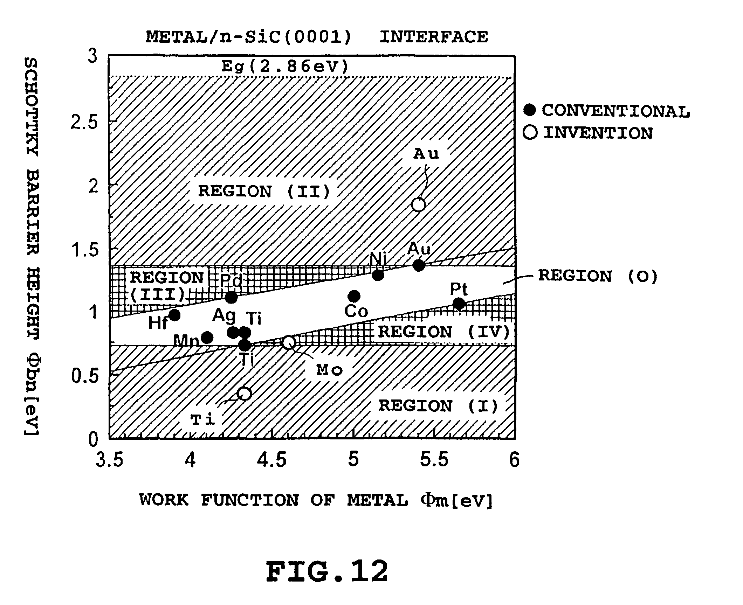

Fig. 12 illustrates Schottky barrier heights of Schottky electrodes fabricated on 6H-SiC (0001) faced substrates by the conventional method and by the methods of the examples of the present invention. For strict comparison, conventional electrodes were fabricated on clean surfaces and I-V characteristics values measured at room temperature were used. The data of the conventional electrodes exist in the region (0). Ti, Mo and Au electrodes subjected to oxidation/etching treatment and boiling water treatment according to the present invention are plotted in regions (I), (IV) and (II), respectively. The data show that the present invention made it possible to realize Schottky barrier heights beyond the lower limit (region (I)) and beyond the upper limit (region (II) that were impossible to achieve by the conventional method. The Mo electrode plotted in region (IV) gives the same Schottky barrier height as that of the conventional Ti electrode having lower work function. This means that to give a certain Schottky barrier height, those metals that were considered inappropriate in view of pinning action can be used in the method of the present invention.

As described above, Schottky barrier height of SiC semiconductors can be freely controlled.

Table 2 summarizes the results of the Background examples, Comparative examples, and Specific examples above.

Table 2

| | Substrate | Electrode Metal | Treatment | Figure | Interface Resistance ($10^{-2}\Omega$cm$^2$) | Reverse Direction Leakage Current (A/cm$^2$) | Surface Unevenness (nm) |
|---|---|---|---|---|---|---|---|
| Ex. 1 | SiC | Ti | A+B | Fig. 3 Line (a) | 6.7 | | |
| C.Ex.1 | SiC | Ti | B | Fig. 4 | | | |
| Ex. 2 | SiC | Al | A+B | Fig. 5 | 1.4 | | |
| Ex. 3 | Si | Al | A+B | Fig. 6 Line (a) | | | |
| | Si | Al | B+C | Fig. 6 Line (b) | | | |
| | Si | Al | A+B+C | Fig. 6 Line (c) | | | |
| C.Ex.2 | Si | Al | B | Fig. 7 | | | |
| Ex. 4 | SiC | Ti | A+B | Fig. 8A, Fig. 8B | | | 5≥ |
| C.Ex.3 | SiC | Ni | Cleaning* Heating 1,000°C | Fig. 9A, Fig. 9B | | | 200 |

EP 0 789 388 B1

Table 2 (Continued)

| | Substrate | Electrode Metal | Treatment | Figure | Interface Resistance ($10^{-2}\,\Omega\mathrm{cm}^2$) | Reverse Direction Leakage Current ($\mathrm{A/cm}^2$) | Surface Unevenness (nm) |
|---|---|---|---|---|---|---|---|
| Ex. 5 | SiC (Bulk) | Ti | A+B+C | Fig. 3 Line (c) | 1.2 | | |
| | SiC-SiC (Epitaxial) | Ti | A+B+C | Fig. 3 Line (d) | 0.6 | | |
| Ex. 6 | SiC | Ti | A+B' | Fig. 3 Line (b) | 1.5 | | |
| Ex. 7 | 6H-SiC (0001) | Au | A+B | Fig. 10 | | $10^{-19}$ | |
| | 6H-SiC (0001) | Au | A+B+C | Fig. 10 | | $10^{-21}$ | |
| C.Ex.4 | 6H-SiC (0001) | Au | B | Fig. 10 | | $10^{-7}$ | |
| Ex. 8 | 6H-SiC (0001) | Ti, Mo, Ni | A+B+C | Fig. 11 | | | |

*: with methanol and trichloroethylene

The present invention has been described in detail with respect to an embodiment, and in the appended claims

**EP 0 789 388 B1**

**Claims**

1. A method of manufacturing a Schottky contact on a semiconductor substrate, comprising the steps of:

   providing a semiconductor substrate having a 6H-SiC (0001) face;
   oxidizing the 6H-SiC (0001) face surface of the semiconductor substrate to form an oxide film;
   removing said oxide film; then
   immersing the 6H-SiC (0001) face surface of said semiconductor substrate in boiling water so as to flatten that surface; and then
   depositing electrode metal for forming a Schottky contact on the flattened 6H-SiC (0001) face surface of said semiconductor substrate and forming therefrom said Schottky contact.

2. A method according to claim 1 wherein said step of oxidizing the surface is performed by heating in an oxidative gaseous atmosphere.

3. A method according to either preceding claim wherein the step of removing said oxide film is carried out by reacting the film oxide with a reducing liquid or gas.

4. A method according to any preceding claim wherein the step of depositing electrode metal produces a layer of said electrode metal and the contact is formed therefrom by patterning said layer.


**Patentansprüche**

1. Verfahren zur Herstellung eines Schottky-Kontakts auf einem Halbleitersubstrat, welches die Schritte umfaßt:

   Bereitstellen eines Halbleitersubstrats mit einer 6H-SiC (0001) Ebene;
   Oxidieren der Oberfläche der 6H-SiC (0001) Ebene des Halbleitersubstrats, um einen Oxidfilm zu bilden;
   Entfernen des Oxidfilms;
   Eintauchen der Oberfläche der 6H-SiC (0001) Ebene des Halbleitersubstrats in siedendes Wasser, um die Oberfläche zu glätten; und dann
   Abscheiden von Elektrodenmetall zum Bilden eines Schottky-Kontakts auf der Oberfläche der geglätteten 6H-SiC (0001) Ebene des Halbleitersubstrats und daraus Bilden des Schottky-Kontakts.

2. Das Verfahren nach Anspruch 1, wobei der Schritt des Oxidierens der Oberfläche durch Erhitzen in einer oxidativen Gasatmosphäre durchgeführt wird.

3. Das Verfahren nach einem der vorhergehenden Ansprüche, wobei der Schritt des Entfernens des Oxidfilms durch Reagieren des Oxidfilms mit einer reduzierenden Flüssigkeit oder einem reduzierenden Gas ausgeführt wird.

4. Das Verfahren nach einem der vorhergehenden Ansprüche, wobei der Schritt des Abscheidens des Elektrodenmetalls eine Schicht des Elektrodenmetalls herstellt und der Kontakt davon durch das Mustern der Schicht gebildet wird.


**Revendications**

1. Procédé de fabrication d'un contact de Schottky sur un substrat semi-conducteur, comprenant les stades dans lesquels :

   on prévoit un substrat semi-conducteur ayant une face (0001) de SiC 6H ;
   on oxyde la surface de la face (0001) de SiC 6H du substrat semi-conducteur pour former une pellicule d'oxyde ;
   on élimine la pellicule d'oxyde ; puis
   on immerge la surface de la face (0001) de SiC 6H du substrat semi-conducteur dans de l'eau bouillante de manière à aplanir cette surface ; et ensuite
   on dépose un métal formant électrode en formant un contact de Schottky sur la surface aplanie de la face (0001) de SiC 6H du substrat semi-conducteur et on en forme le contact de Schottky.

**2.** Procédé suivant la revendication 1, dans lequel on effectue le stade d'oxydation de la surface en chauffant dans une atmosphère gazeuse oxydante.

**3.** Procédé suivant l'une quelconque des revendications précédentes, dans lequel on effectue le stade d'élimination de la pellicule d'oxyde en faisant réagir la pellicule d'oxyde sur un gaz ou sur un liquide réducteur.

**4.** Procédé suivant l'une quelconque des revendications précédentes, **caractérisé en ce que** le stade de dépôt d'un métal formant électrode produit une couche de métal formant électrode et le contact en est formé en structurant la couche.

**FIG.1**
**(PRIOR ART)**

FIG.2

FIG.3

FIG.4

**A1 ELECTRODE ON SiC**

$N_D = 2 \times 10^{17} cm^{-3}$

$\rho_C = 1.4 \times 10^{-2} \Omega cm^2$

5

**FIG.5**

A1 ELECTRODE
ON Si
$N_D = 7 \times 10^{16} \text{cm}^{-3}$

6a

6b

6c
$\rho_C = 1.5 \Omega \text{cm}^2$

CURRENT DENSITY [A/cm²]

VOLTAGE [V]

FIG.6

21

**FIG.7**

FIG.8A

14

11

12

100µm

FIG.8B

14

X1

12

11

FIG.9A

100μm

FIG.9B

FIG.10

FIG.11

METAL/n-SiC(0001)  INTERFACE

FIG.12

EP 0 789 388 B1